# EUROPÄISCHE PATENTANMELDUNG

(11) **EP 1 276 357 A2**
(43) Veröffentlichungstag der Anmeldung: **15.01.2003**
(21) Anmeldenummer: 02015752.5
(22) Anmeldetag: 13.07.2002
(51) Int. Cl.: H05K 1/02, H05K 7/20

(54) **Leiterplatte für elektrische Schaltungen**

(30) Priorität: 13.07.2001 DE 10134064
(71) Anmelder: Behr-Hella Thermocontrol GmbH, D-70469 Stuttgart (DE)
(72) Erfinder: Röhling, Hans-Dieter, 59558 Lippstadt (DE)
(74) Vertreter: Hilleringmann, Jochen, Dipl.-Ing.

(57) **Zusammenfassung**

Die Leiterplatte für elektrische Schaltungen ist mit einer Trägerplatte (12) versehen, die eine Ober- und eine Unterseite (14,16) aufweist, wobei sich in mindestens einer dieser Seiten (14,16) der Trägerplatte (12) eine von einem Rand begrenzte Ausnehmung (22) befindet. Ferner ist die Leiterplatte mit einem ein elektrisch leitendes Material aufweisenden Wärmeleitelement (24) versehen, das in die mindestens eine Ausnehmung (22) eingepasst und im wesentlichen mit der betreffenden Seite (14,16) der Trägerplatte (12) fluchtend angeordnet ist. Auf mindestens der mit der mindestens einen Ausnehmung (22) versehenen Seite (14,16) der Trägerplatte (12) verlaufen Leiterbahnen (32) aus elektrisch leitendem Material. Das Wärmeleitelement (24) ist von dem elektrisch leitenden Material der Leiterbahnen (32) überdeckt und diese Überdeckung (34) erstreckt sich zumindest bereichsweise bis über den Rand der Ausnehmung (22).

## Beschreibung

Die Erfindung betrifft eine Leiterplatte für elektrische Schaltungen mit einer integrierten Insel aus wärmeleitendem Material zum Zweck der Wärmeab- und verteilung.

Die Bauteile von elektrischen Schaltungen werden im Regelfall auf Trägerplatten angeordnet, die zumindest einseitig mit Leiterbahnen versehen sind. Je nach Funktion und Größe der einzelnen elektrischen bzw. elektronischen Bauteile erzeugen diese eine nicht unbeträchtliche Verlustwärme, die an die Umgebung abgeführt werden muss. Hierzu bedient man sich mitunter spezieller Kühlkörper, die an den Bauteilen direkt angebracht sind.

Im Stand der Technik ist es bekannt, zum Zwecke der Wärmeverteilung massive Materialblöcke bzw. -platten aus wärmeleitendem Material (zumeist Kupfer) in entsprechende Aussparungen einer Leiterplatte einzupressen. Dabei ist bisher die elektrische Anbindung dieser Wärmeleitelemente zum Zwecke der Stromführung und der mechanische Halt des Wärmeleitelements in der Leiterplatte problematisch. Der zuverlässige mechanische Halt des Wärmeleitelements in der Leiterplatte ist insbesondere in Umgebungen, in denen die Leiterplatte mehr oder weniger starken mechanischen Kräften ausgesetzt ist, wie dies beispielsweise in einem Kfz der Fall ist, unabdingbare Voraussetzung.

Der Erfindung liegt die Aufgabe zu Grunde, eine Leiterplatte mit einem in dieser integrierten Wärmeleitelement zu schaffen, das mechanisch zuverlässig in der Leiterplatte gehalten ist.

Zur Lösung dieser Aufgabe wird mit der Erfindung eine Leiterplatte für elektrische Schaltungen vorgeschlagen, die versehen ist mit
- einer Trägerplatte, die eine Ober- und eine Unterseite aufweist, wobei sich in mindestens einer dieser Seiten der Trägerplatte eine von einem Rand begrenzte Ausnehmung befindet,
- einem ein elektrisch leitendes Material aufweisenden Wärmeleitelement, das in die mindestens eine Ausnehmung eingepasst und im wesentlichen mit der betreffenden Seite der Trägerplatte fluchtend angeordnet ist, und
- Leiterbahnen auf mindestens der mit der mindestens einen Ausnehmung versehenen Seite der Trägerplatte, wobei die Leiterbahnen elektrisch leitendes Material aufweisen,
- wobei das Wärmeleitelement mit dem elektrisch leitenden Material der Leiterbahnen überdeckt ist und sich diese Überdeckung zumindest bereichsweise bis über den Rand der Ausnehmung erstreckt.

Insbesondere wird zur Lösung der obigen Aufgabe mit der Erfindung eine Leiterplatte für elektrische Schaltungen vorgeschlagen, die versehen ist mit
- einer Trägerplatte, die eine Ober- sowie eine Unterseite und eine sich zwischen beiden Seiten erstreckende von einem Rand begrenzte Ausnehmung aufweist,
- einem ein elektrisch leitendes Material aufweisenden Wärmeleitelement, das in die mindestens eine Ausnehmung eingepresst und im wesentlichen mit beiden Seiten der Trägerplatte fluchtend sowie an beiden Seiten freiliegenden angeordnet ist, und
- Leiterbahnen auf mindestens einer der Seiten der Trägerplatte, wobei die Leiterbahnen elektrisch leitendes Material aufweisen,
- wobei das Wärmeleitelement von dem elektrisch leitenden Material der Leiterbahnen überdeckt ist und sich diese Überdeckung zumindest bereichsweise bis über den Rand der Ausnehmung erstreckt.

Nach der Erfindung wird das Wärmeleitelement, das sich in einer Ausnehmung der Trägerplatte befindet, an diese mechanisch auf Grund seiner Presspassung sowie mittels einer das Wärmeleitelement zumindest teilweise überdeckenden und insbesondere vollflächig überdeckenden Materialüberdeckung angebunden, wobei dieser Überdeckung aus demjenigen Material besteht, aus dem auch die Leiterbahnen auf der Trägerplatte bestehen. Diese Materialüberdeckung erfolgt automatisch bei der Herstellung der Leiterbahnen (durch so genanntes galvanisches Aufkupfern), weshalb für die erfindungsgemäße Fixierung der Überdeckung des Wärmeleitelements, die zusätzlich zu dem Einpressen des Wärmeleitelements in der Ausnehmung der Trägerplatte vorgesehen ist, ohne zusätzlichen Arbeitsaufwand bzw. Arbeitsschritt erfolgt.

Bei der Herstellung einer Leiterplatte wird von einer Trägerplatte aus einem Epoxitharz oder FR4-Material ausgegangen, deren Oberfläche (ein- oder zweiseitig) mit einer dünnen Kupferschicht versehen ist. Die kupferbeschichtete Ober- und/oder Unterseite der Trägerplatte wird anschließend mit dem zu erstellenden Layout belichtet, nachdem zuvor eine Fotolackschicht aufgetragen worden ist. Nach weiteren hier nicht näher zu beschreibenden Herstellungsschritten werden schließlich diejenigen Bereiche der kupferbeschichteten Trägerplatte freigelegt, auf denen vom Layout her Leiterbahnen verlaufen. In diesen Bereichen wird nun galvanisch Kupfermaterial abgeschieden (so genanntes Aufkupfern), so dass die Kupferschicht im Bereich der Leiterbahnen wesentlich dicker ist als die Kupferschicht der unbearbeiteten Trägerplatte.

Erfindungsgemäß ist nun vor dem Aufkupfern der Leiterbahnen in eine in die Trägerplatte eingebrachte Ausnehmung ein Wärmeleitelement (zumeist Wärmeleitplattenelement) eingepasst worden, wobei dieses Wärmleitplattenelement aus einem wärmeleitenden Material besteht, das die galvanische Abscheidung von elektrischem Material erlaubt. Das Wärmeleitelement weist eine mit der Oberfläche der Trägerplatte fluchtende Fläche auf. Beim galvanischen Aufkupfern wird diese Fläche des Wärmeleitelements ebenfalls überkupfert. Damit ist das Wärmeleitelement zumindest an einer Seite (bei beidseitig mit Leiterbahnen versehenen Trägerplatten und als durchgehende Aussparung ausgebildete Ausnehmung auch beidseitig) von Kupfer oder, allgemeiner ausgedrückt, dem elektrisch leitenden Material der Leiterbahnen überdeckt und stoffschlüssig (wegen des galvanischen Abscheidungsprozesses) mit der Layout-Schicht der Trägerplatte verbunden. Diese Verankerung des Wärmeleitelements in der Leiterplatte ist recht zuverlässig, weshalb die Ausdrückfestigkeit des Wärmeleitelements der erfindungsgemäßen Leiterplatte erhöht ist, was den Einsatz der erfindungsgemäßen Leiterplatte in rauen Betriebsumgebungen mit starken mechanischen Erschütterungen ermöglicht. Überdies lässt sich das Wärmeleitelement auf denkbar einfache Weise kontaktieren, indem es in den Layout der Leiterplatte mit eingebunden und Bestandteil dieses Layouts ist. Leiterbahnen können also direkt von dem Wärmeleitelement weg führen. Für die elektrische Anbindung des Wärmeleitelements ist es also nicht länger erforderlich, dass direkt auf dem Wärmeleitelement der Anschluss eines Bauteils kontaktiert werden muss.

Die erfindungsgemäße Leiterplatte kann mit mehreren auf die oben beschriebene Weise elektrisch und mechanisch in das Layout eingebundenen Wärmeleitelementen versehen sein. Diese Wärmeleitelemente können entweder in einer einseitigen Ausnehmung, d.h. Vertiefung der Leiterplatte eingepresst oder in eine von der Ober- bis zur Unterseite führenden durchgehenden Aussparung der Leiterplatte angeordnet bzw. eingepasst sein. Die letztgenannte Variante bietet die Möglichkeit, das Wärmeleitelement beidseitig mechanisch zu fixieren und elektrisch zu kontaktieren.

Zur Erhöhung des Wärmetransports von dem Wärmeleitelement in die Umgebung kann es zweckmäßig sein, das Wärmeleitelement mit Kühlfingern zu versehen, die von dem Wärmeleitelement und damit im eingebauten Zustand von der Leiterplatte abstehen. Diese Kühlfinger können entweder von oben auf die das Wärmeleitelement überdeckende Überdeckungsschicht angebracht sein oder aber die Kühlfinger sind integraler Bestandteil des Wärmleitelements, so dass sie nach der Fertigstellung der Leiterplatte aus der das Wärmeleitelement überdeckenden Überdeckungsschicht herausragen.

Die Erfindung wird nachfolgend anhand eines Ausführungsbeispiel unter Bezugnahme auf die Zeichnung näher erläutert. Dabei zeigen im einzelnen:
- Fig. 1: einen Querschnitt durch eine Leiterplatte mit beidseitiger Kupferbeschichtung und eingepasstem Wärmeleitelement,
- Fig. 2: einen Querschnitt durch die Leiterplatte nach dem Aufkupferungsprozess,
- Fig. 3: die Leiterplatte gemäß Fig. 2 mit aufgesetztem zusätzlichem Kühlkörper und
- Fig. 4: eine Variante der Ausgestaltung gemäß Fig. 3, bei der der zusätzliche Kühlkörper integraler Bestandteil des Wärmeleitelements ist.

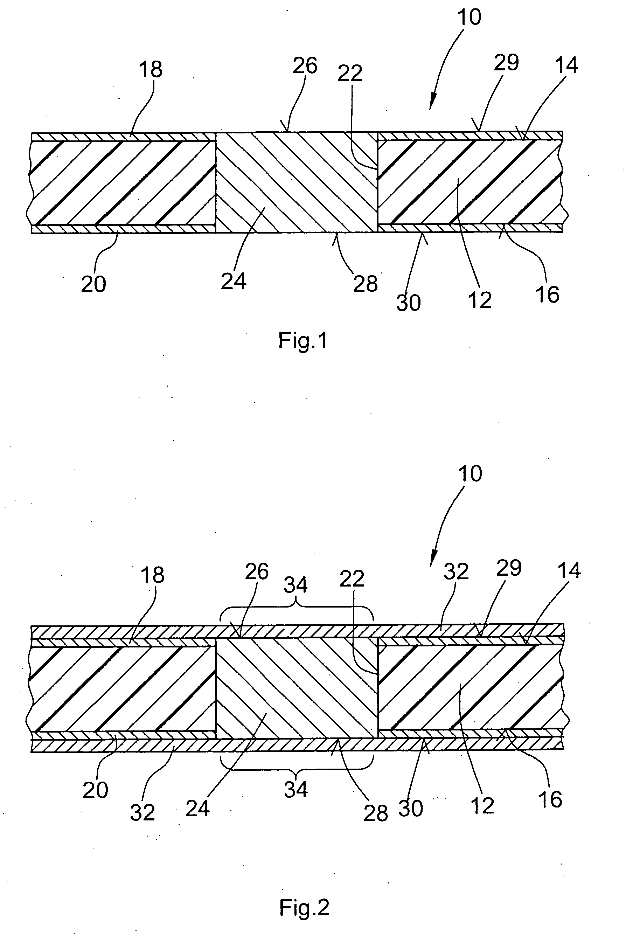

Fig. 1 zeigt einen ausschnittsweisen Querschnitt durch eine Leiterplatte 10, die eine Trägerplatte 12 aus einem Kunststoffmaterial aufweist, dessen Ober- und Unterseite 14,16 mit einer Kupferschicht 18,20 versehen ist. Diese Kupferschichten 18,20 sind zur Ausbildung von Leiterbahnen an sich zu dünn und dienen lediglich dazu, dass sich auf ihnen in einem späteren galvanischen Prozess das zur Ausbildung der Leiterbahnen erforderliche Kupfermaterial abscheiden kann.

In die Leiterplatte 10 ist von der Ober- bis zur Unterseite 14,16 der Trägerplatte 12 und durch die Kupferschichten 18,20 hindurch eine Durchgangsaussparung 22 ausgebildet, in die ein Wärmeleitelement 24 in Form einer Platte bzw. eines Blocks aus ebenfalls Kupfer eingepasst bzw. eingepresst ist. Die Ober- und die Unterseite 26,28 des Wärmeleitelements 24 fluchten mit den Außenseiten 29,30 der Kupferschichten 18,20.

Nachdem auf den Außenseiten 29,30 der Kupferschichten 18,20 durch mehrere an sich bekannte Prozessschritte diejenigen Bereiche der Kupferschichten 18,20 freigelegt worden sind, auf denen Leiterbahnen entstehen sollen, wird die Leiterplatte 10 einem galvanischen Prozess ausgesetzt, bei dem Kupfer auf den Kupferschichten 18,20 abgeschieden wird. Während dieses Prozessschrittes liegen auch die Ober- und Unterseite 26,28 des Wärmeleitelements 24 frei, so dass sich das in Fig. 2 bei 32 angedeutete Layout (d.h. die Leiterbahnen 32) über das Wärmeleitelement 24 erstrecken und dieses überdecken (siehe Bezugszeichen 34 in Fig. 2).

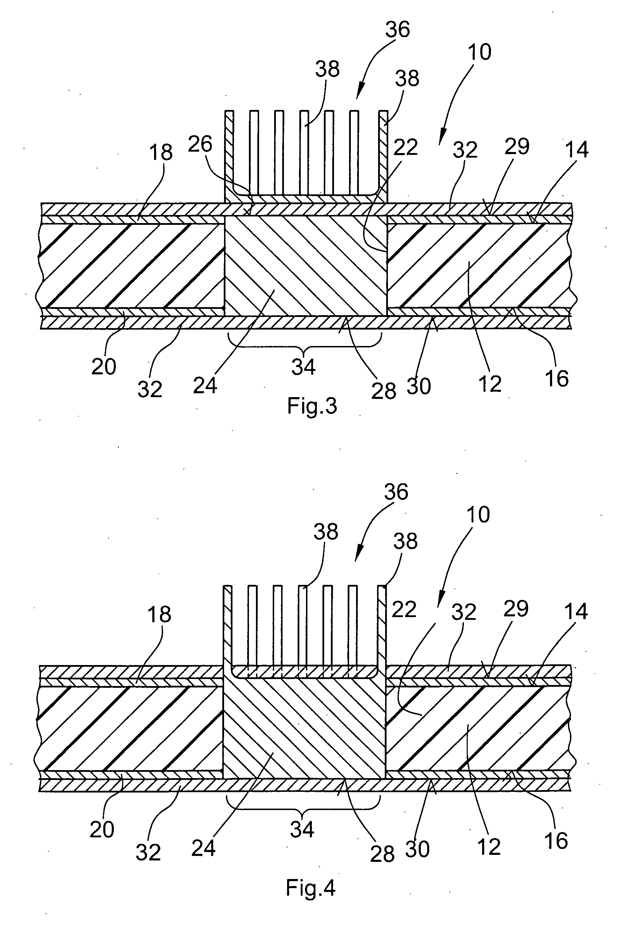

Auf die zuvor beschriebene Weise ist somit das Wärmeleitelement 24 sowohl mechanisch stoffschlüssig mit dem Layout 32 verbunden als auch elektrisch an dieses angebunden. Die stoffschlüssige Verbindung zum Layout 32 sorgt nicht nur für den zuverlässigen mechanischen Halt des Wärmeleitelements 24 in der Leiterplatte 10, sondern verbessert auch die Wärmeabfuhr zur Umgebung, da nunmehr auch Wärme vom Wärmeleitelement 24 in das Layout 32 und von dort großflächig an die Umgebung abfließen kann. Es ist aber auch möglich, auf die Überdeckung 34 ein separates Kühlelement 36 mit Kühlfingern 38 o.dgl. abstehenden Elemente anzubringen. Diese Situation ist in Fig. 3 gezeigt.

Die Variante gemäß Fig. 4 bezieht sich darauf, dass das zusätzliche Kühlelement 36 integraler Bestandteil des Wärmeleitelements 24 ist, so dass bereits vor dem Aufkupferungsschritt der Fig. 2 die Kühlfinger 38 von der Ober- bzw. Unterseite 26,28 des Wärmeleitelements 24 abstehen, die Kühlfinger 38 nach dem Aufkupferungsprozess also sozusagen in dem Kupfermaterial des Layouts 32 eingebettet sind.

### BEZUGSZEICHENLISTE

- 10: Leiterplatte
- 12: Trägerplatte
- 14: Oberseite
- 16: Unterseite
- 18: Kupferschicht
- 20: Kupferschicht
- 22: Durchgangsaussparung
- 24: Wärmeleitelement
- 26: Oberseite
- 28: Unterseite
- 29: Außenseite
- 30: Außenseite
- 32: Leiterbahn
- 34: Überdeckung
- 36: Kühlelement
- 38: Kühlfinger

## Patentansprüche

1. Leiterplatte für elektrische Schaltungen, mit
- einer Trägerplatte (12), die eine Ober- und eine Unterseite (14,16) aufweist, wobei sich in mindestens einer dieser Seiten (14,16) der Trägerplatte (12) eine von einem Rand begrenzte Ausnehmung (22) befindet,
- einem ein elektrisch leitendes Material aufweisenden Wärmeleitelement (24), das in die mindestens eine Ausnehmung (22) eingepasst und im wesentlichen mit der betreffenden Seite (14,16) der Trägerplatte (12) fluchtend angeordnet ist, und
- Leiterbahnen (32) auf mindestens der mit der mindestens einen Ausnehmung (22) versehenen Seite (14,16) der Trägerplatte (12), wobei die Leiterbahnen (32) elektrisch leitendes Material aufweisen,
- wobei das Wärmeleitelement (24) von dem elektrisch leitenden Material der Leiterbahnen (32) überdeckt ist und sich diese Überdeckung (34) zumindest bereichsweise bis über den Rand der Ausnehmung (22) erstreckt.

2. Leiterplatte nach Anspruch 1, **dadurch gekennzeichnet, dass** mindestens eine der Ausnehmungen (22) als von der Ober- bis zur Unterseite (14,16) der Trägerplatte (12) führende Aussparung ausgebildet ist und dass das in diese Aussparung eingepasste Wärmeleitelement (24) mit der Oberund der Unterseite (14,16) der Trägerplatte (12) im wesentlichen fluchtet.

3. Leiterplatte nach Anspruch 1, **dadurch gekennzeichnet, dass** mindestens eine der Ausnehmungen (22) als von der Ober- bis zur Unterseite (14,16) der Trägerplatte (12) führende Aussparung ausgebildet ist, dass das in diese Aussparung eingepasste Wärmeleitelement (24) mit der Ober- und der Unterseite (14,16) der Trägerplatte (12) im wesentlichen fluchtet.

4. Leiterplatte nach einem der Ansprüche 1 bis 3, **dadurch gekennzeichnet, dass** auf der Ober- und der Unterseite (14,16) der Trägerplatte (12) Leiterbahnen (32) angeordnet sind, wobei das Wärmeleitelement (24) beidseitig von dem elektrisch leitenden Material der Leiterbahnen (32) überdeckt ist und sich die Überdeckungen (34) zumindest bereichsweise bis über die Ränder der Aussparung (22) an der Ober- und der Unterseite (14,16) der Trägerplatte (12) erstrecken.

5. Leiterplatte nach einem der Ansprüche 1 bis 4, **dadurch gekennzeichnet, dass** von dem Wärmeleitelement (24) Kühlfinger (38) abstehen.

6. Leiterplatte nach einem der Ansprüche 1 bis 5, **dadurch gekennzeichnet, dass** sich von dem Wärmeleitelement (24) aus über die Ober- und/oder Unterseite (14,16) der Trägerplatte (12) mindestens eine Leiterbahn (32) erstreckt.

7. Leiterplatte nach einem der Ansprüche 1 bis 6, **dadurch gekennzeichnet, dass** die Trägerplatte (12) eine Beschichten (18,20) aus elektrisch leitendem Material aufweist, mit deren Außenseite (29,30) das Wärmeleitelement (24) im wesentlichen fluchtet, und dass auf die Beschichtung (18,20) die Leiterbahnen (32) und auf das Wärmeleitelement (24) die Überdeckung (34), beides aus elektrisch leitendem Material, aufgebracht sind.
